# EUROPÄISCHE PATENTANMELDUNG

(11) **EP 4 142 057 A1**
(43) Veröffentlichungstag der Anmeldung: **01.03.2023**
(21) Anmeldenummer: 22183003.7
(22) Anmeldetag: 05.07.2022
(51) Int. Cl.: H01R 4/02, H01R 12/53, H01R 12/70, H01R 9/05

(54) **VERBINDER UND VERFAHREN ZUM VERBINDEN EINER LEITERPLATTE MIT ZUMINDEST EINEM LEITER**

(30) Priorität: 30.08.2021 DE 102021122329
(71) Anmelder: MD Elektronik GmbH, 84478 Waldkraiburg (DE)
(72) Erfinder: Trä, Johannes, 84453 Mühldorf am Inn (DE)

(57) **Zusammenfassung**

Die vorliegende Erfindung betrifft einen Verbinder (1, 100) zum Verbinden einer Leiterplatte (20), die zumindest ein Lötpad (24) aufweist, mit zumindest einem Leiter (32) einer Leitung (30), aufweisend Befestigungsmittel (2), mit Hilfe derer der Verbinder (1, 100) an der Leiterplatte (20) befestigbar ist, eine Aussparung (10), die an einer ersten Seite (11) des Verbinders (1, 100) gebildet ist, und die sich zumindest über eine zweite Seite (12), die quer zur ersten Seite (11) angeordnet ist, erstreckt, wobei in einem montierten Zustand des Verbinders (1, 100) auf der Leiterplatte (20) das zumindest eine Lötpad (24) in der Aussparung (10) auf der ersten Seite (11) anordbar ist und die Aussparung (10) auf der zweiten Seite (12) eine erste Öffnung (4) bildet, in die der zumindest eine Leiter (32) einführbar ist, und eine zweite Öffnung (6), die an einer der ersten Seite (11) gegenüberliegenden dritten Seite (13) gebildet ist, wobei über die zweite Öffnung (6) Wärme zum Verbinden des zumindest einen Leiters (32) mit dem zumindest einen Lötpad (24) bereitgestellt werden kann. Die Erfindung betrifft weiterhin eine Leiterplatte (20) sowie ein Verfahren zum Verbinden einer Leiterplatte (20) mit zumindest einem Leiter (32) einer Leitung (30).

## Beschreibung

### Technisches Gebiet

Die Erfindung betrifft einen Verbinder und ein Verfahren zum Verbinden einer Leiterplatte mit zumindest einem Leiter, sowie eine Leiterplatte zum direkten Verbinden mit zumindest einem Leiter.

### Stand der Technik

Bei der Herstellung einer elektrischen Verbindung zwischen einem Leiter einer Leitung und einer Leiterplatte weist die Verbindungstechnik im Stand der Technik oftmals mehrere und/oder sperrige Bauteile auf.

Die Druckschrift WO 02/084808 A1 beschreibt einen Leiterplattenverbinder zur Aufnahme eines Kabelendes, der so eingerichtet ist, dass er an einer Leiterplatte befestigt werden kann. Der Leiterplattenverbinder weist ein Durchgangsloch auf, in das das Kabelende eingeführt und der Innenleiter durchgesteckt wird, wobei der Innenleiter außerhalb des Leiterplattenverbinders an einen Mikrostreifenleiter auf der Leiterplatte gelötet wird.

Die Druckschrift EP 2 690 712 A2 beschreibt eine Anschlussvorrichtung zur Verbindung eines HF-Koaxialkabels mit einer Leiterplatte. Die Leiterplatte umfasst einen ausgeschnittenen Bereich, in dem ein Teil eines Randes ausgeschnitten ist, sowie ein Paar von Durchgangslöchern, die auf beiden Seiten des ausgeschnittenen Bereichs ausgebildet sind. Der ausgeschnittene Bereich ist an einer vorbestimmten Position des Umfangs der Leiterplatte gebildet und umfasst eine Öffnung, die sich nach außen hin öffnet, während die Durchgangslöcher geschlossene Öffnungen mit einer kreisförmigen Form umfassen. Der ausgeschnittene Bereich ist ein Raum in dem ein zentraler Körper des Lötblocks und das HF-Koaxialkabel angeordnet und verlötet werden, während die Durchgangslöcher Räume sind, in denen Hilfskörper des Lötblocks eingesetzt und verlötet werden.

Die Druckschrift US 2007/054510 A1 beschreibt Systeme und Verfahren zum Verbinden von Koaxialkabeln mit Leitern auf einer Leiterplatte. Insbesondere beschreibt die Druckschrift eine Vorrichtung zum Verbinden eines Koaxialkabels mit einer Leiterplatte, wobei die Vorrichtung einen Verbinder umfasst, der ein elektrisch leitendes Element mit einer Aufnahme umfasst, die ein Ende des Koaxialkabels aufnimmt, um das Koaxialkabel mit einem Leiter auf der Leiterplatte zu verbinden, und eine Abschirmung, die direkt mit dem Verbinder und der Leiterplatte verbunden ist, um parasitäre Strahlung zu verhindern.

Die Druckschrift US 2021/0006012 A1 beschreibt einen Leiterplattenverbinder mit einer Montageschnittstelle, die für die Oberflächenmontage an eine Leiterplatte eingerichtet ist, wobei der Leiterplattenverbinder eine Aussparung zur Aufnahme eines komplementären Verbinders zum Anschluss mehrerer Drähte aufweisen kann.

Zusammengefasst weisen die Systeme im Stand der Technik einen deutlichen Bauraum auf der Leiterplatte auf, oftmals verbunden mit zusätzlichen Elementen, die erforderlich sind, sowie einem erhöhten Verarbeitungsaufwand.

### Beschreibung der Erfindung

Es ist daher eine Aufgabe der vorliegenden Erfindung eine Vorrichtung und ein Verfahren zur Verbindung einer Leiterplatte mit zumindest einem Leiter bereitzustellen, wobei eine bestmögliche Verbindung mit wenig Bauteilen und Montageschritten, und auf kleinstem Bauraum, bevorzugt automatisiert, hergestellt wird.

Die oben genannte Aufgabe wird durch einen Verbinder nach Anspruch 1, eine Leiterplatte nach Anspruch 12, sowie ein Verfahren nach Anspruch 13 gelöst. Weitere vorteilhafte Ausgestaltungsformen der Erfindung lassen sich den Unteransprüchen, der Beschreibung sowie den Zeichnungen entnehmen.

Insbesondere wird die oben genannte Aufgabe gelöst durch einen Verbinder zum Verbinden einer Leiterplatte, die zumindest ein Lötpad aufweist, mit zumindest einem Leiter einer Leitung, aufweisend Befestigungsmittel, mit Hilfe derer der Verbinder an der Leiterplatte befestigbar ist, eine Aussparung, die an einer ersten Seite des Verbinders gebildet ist, und die sich zumindest über eine zweite Seite, die quer zur ersten Seite angeordnet ist, erstreckt, wobei in einem montierten Zustand des Verbinders auf der Leiterplatte das zumindest eine Lötpad in der Aussparung auf der ersten Seite anordbar ist und die Aussparung auf der zweiten Seite eine erste Öffnung bildet, in die der zumindest eine Leiter einführbar ist, und eine zweite Öffnung, die an einer der ersten Seite gegenüberliegenden dritten Seite gebildet ist, wobei über die zweite Öffnung Wärme zum Verbinden des zumindest einen Leiters mit dem zumindest einen Lötpad bereitgestellt werden kann.

Der Verbinder ist eine Konfektionshilfe zum Herstellen einer dauerhaften und elektrisch leitfähigen Verbindung zwischen einer Leiterplatte und zumindest einem Leiter. Dabei ist die Verbindung eine direkte Verbindung, d.h. ohne ein Anschluss-oder Steckersystem. Die direkte Verbindung hat den Vorteil, dass Bauteile eingespart werden und weniger Bauraum bereitgestellt werden muss. Die Verbindung kann zudem mit wenigen Schritten und auch automatisiert eingerichtet werden. Der für eine zuverlässige Verbindung von Leiterplatte und Verbinder notwendige Anpressdruck kann in der automatisierten Fertigung von Pick-and-Place Automaten sichergestellt werden. Die Leiterplatte wird bei der Verbindung als primäres Lötdepot verwendet und die Konfektionshilfe wird auch nur leiterplattenseitig benötigt. Die anzuschließende Leitung bzw. der zumindest eine freigelegte Leiter muss nicht notwendigerweise vorbehandelt sein. Das spart Zeit und ermöglicht die Verarbeitung auf engem Raum.

Bevorzugt ist der Verbinder eingerichtet parallel eine Mehrzahl von Leitern mit einer entsprechenden Mehrzahl an Lötpads zu verbinden, wobei insbesondere die erste Öffnung eine Breite aufweist, die geeignet ist die Mehrzahl von Leitern parallel aufzunehmen. Eine Mehrzahl an Leitern kann mehr als fünf, insbesondere mehr als 10 Leiter umfassen. Durch die Form des Verbinders, insbesondere durch die Breite der ersten Öffnung, kann eine Mehrzahl an Leitern dicht beieinanderliegend mit der Leiterplatte verbunden werden. Dadurch ist ein kompakter, platzsparender Aufbau des Verbinders und der gesamten Verbindung möglich.

Bevorzugt ist im montierten Zustand zumindest eine Seite der ersten Öffnung aus der Leiterplatte gebildet. Dadurch ist es möglich, dass eingeführte Leiter so nah wie möglich an der Leiterplatte angeordnet werden können, d.h. es liegt nur noch das Lötpad zwischen Leiter und Leiterplatte. Somit ist eine platzsparende Verbindung, die wenig Bauraum benötigt, möglich.

Bevorzugt umfassen die Befestigungsmittel Pins oder Stifte, die in entsprechende Öffnungen an der Leiterplatte eingreifbar sind. Die Pins oder Stifte oder vergleichbare Befestigungsmittel geben dem Montagepersonal, aber auch einem Platzierungssystem eines Automaten, ein gut wahrnehmbares visuelles und/oder haptisches Feedback und erleichtern so die Anordnung des Verbinders auf der Leiterplatte. Weiterhin kann durch die Anordnung und Anzahl an Befestigungsmitteln eine Ausrichtung des Verbinders auf der Leiterplatte vorgegeben werden. Die Pins oder Stifte können eine dauerhafte oder lösbare Verbindung einfach und sicher bereitstellen.

Bevorzugt weist der Verbinder an der ersten Seite Klebeflächen auf. Die Klebeflächen können zusätzliche oder alternative Befestigungsmittel bilden. Die Klebeflächen können über Klebepunkte auf den Verbinder und/oder die Leiterplatte aufgebracht sein. Die Klebeflächen sichern die Befestigung des Verbinders an der Leiterplatte.

Bevorzugt entspricht im montierten Zustand eine Höhe der ersten Öffnung einem Durchmesser des zumindest einen Leiters. Im montierten Zustand füllt ein eingeführter Leiter im Wesentlichen die gesamte Höhe der Öffnung bzw. der Aussparung aus, so dass der Verbinder nur so hoch ist wie notwendig. Im Wesentlichen meint dabei, dass noch Platz für ein Lötpad sein muss und an der Außenkante der ersten Öffnung eine Einführhilfe bereitgestellt sein kann. Durch die Höhe der ersten Öffnung kann der Verbinder sehr flach ausgebildet sein, so dass nur wenig Bauraum benötigt wird.

Bevorzugt weist die erste Öffnung zumindest eine Einführhilfe auf. Die Einführhilfe erleichtert das Einführen von Leitern in die erste Öffnung. Da die Durchmesser der eingeführten Leiter in der Regel nur Bruchteile von Millimetern betragen, zum Beispiel in einem Bereich von 0,1 bis 0,9 mm, ist eine Einführhilfe sehr von Vorteil.

Bevorzugt weist die erste Öffnung zumindest ein Ausrichtungsmittel auf. Das Ausrichtungsmittel erleichtert die gerichtete Anordnung von Leitern in dem Verbinder. So kann eine gleichbleibende Anordnung der Leiter in dem Verbinder bzw. auf den Lötpads sichergestellt werden.

Bevorzugt weist der Verbinder weiterhin eine dritte Öffnung auf, die an der dritten Seite gebildet ist, wobei über die dritte Öffnung ein Medium an den zumindest einen Leiter und das zumindest eine Lötpad zugeführt werden kann. Die dritte Öffnung ist bevorzugt beabstandet zur zweiten Öffnung und bildet einen weiteren Zugang zur Aussparung des Verbinders, wobei die Aussparung im montierten Zustand einen Hohlraum bildet. Die dritte Öffnung kann unabhängig von einer Wärmezufuhr an der zweiten Öffnung verwendet werden.

Bevorzugt bildet oder weist die dritte Öffnung ein Depot für das Medium auf. Bevorzugt wird das Depot vor dem Anordnen des Verbinders auf der Leiterplatte mit einer bestimmten Menge an Medium gefüllt. Dabei liegt das Medium bevorzugt in fester Form bei Raumtemperatur, d.h. ohne explizite Wärmezufuhr zum Beispiel beim Löten, in dem Depot des Verbinders vor. Das Depot am Verbinder hat den Vorteil, dass beim Verbinden bzw. Löten der Leiter kein Medium von Extern an dem Verbinder bereitgestellt werden muss. Somit können Prozessabläufe einfacher gestaltet werden.

Bevorzugt ist der Verbinder aus einem nicht-wärmeleitendem Material gebildet. Wenn der Verbinder aus einem nicht-wärmeleitendem Material gebildet ist, dann ist die Wärmezufuhr beim Löten ausschließlich über die zweite Öffnung an den Leitern und den Lötpads bereitzustellen. Dadurch ist ein gerichteter Wärmeeintrag am Verbinder möglich. Der gerichtete Wärmeeintrag stellt eine zuverlässige Verlötung sicher und kann aufgrund nicht-auftretender ungewollter Wärmediffusion energiesparender sein.

Die oben genannten Probleme werden weiterhin insbesondere gelöst durch eine Leiterplatte, die zumindest ein Lötpad und einen Verbinder aufweist, so dass die Leiterplatte direkt mit zumindest einem Leiter einer Leitung verbunden werden kann. Die direkte Verbindung benötigt keine Anschluss- oder Steckersysteme und kommt dadurch mit wenig Bauteilen aus und ist platzsparend. Dabei bietet der Verbinder aufgrund seiner Rahmenstruktur, ähnlich einem Gehäuse, einen Schutz für die Verbindungsflächen zwischen Leitern und Lötpads.

Die oben genannten Probleme werden weiterhin insbesondere gelöst durch ein Verfahren zum Verbinden einer Leiterplatte, die zumindest ein Lötpad aufweist, mit zumindest einem Leiter einer Leitung, wobei das Verfahren die folgenden Schritte aufweist: Anordnen eines Verbinders an einer vorbestimmten Position auf der Leiterplatte, wobei Befestigungsmittel des Verbinders in Eingriff mit der Leiterplatte kommen und das zumindest eine Lötpad in einer Aussparung des Verbinders angeordnet ist, Einführen des zumindest einen Leiters in eine erste Öffnung an dem Verbinder, wobei die Einführbewegung bevorzugt entlang der Leiterplattenebene gerichtet ist, so dass ein eingeführter Leiter innerhalb des Verbinders in Kontakt mit einem Lötpad steht, Einbringen von Wärme über eine zweite Öffnung an dem Verbinder, so dass sich ein eingeführter Leiter mit einem in Kontakt stehenden Lötpad verbindet.

Das Verfahren ermöglicht mit wenigen Schritten eine zuverlässige elektrische Verbindung zwischen zumindest einem Leiter und einer Leiterplatte. Es treten keine Wackelkontakte über die Zeit auf. Die Schritte können manuell oder automatisiert durchgeführt werden. Dies ermöglicht eine effiziente Fertigung.

Bevorzugt wird im Schritt des Einführens des zumindest einen Leiters, der eingeführte Leiter zumindest teilweise in das Lötpad hineingedrückt. Das zumindest teilweise Hineindrücken eines Leiters in ein Lötpad erhöht die Fixierung des Leiters in dem Verbinder aufgrund der klebrigen Eigenschaft des Lötpads, das bevorzugt aus einer Lötpaste gebildet ist. So bleiben eingeführte Leiter auch bei geringen (Zug-) Bewegungen an der Leitung in dem Verbinder fixiert bevor sie durch Löten oder Ähnlichem dauerhaft an der Leiterplatte befestigt werden.

Bevorzugt weist das Verfahren weiterhin den Schritt auf: Einbringen eines Mediums, das die Verbindung zwischen dem zumindest einen Lötpad und dem zumindest einen eingeführten Leiter unterstützt, wobei das Einbringen bevorzugt über eine dritte Öffnung an dem Verbinder erfolgt. Das Einbringen des Mediums erfolgt bevorzugt passiv beim Wärmeeintrag an der zweiten Öffnung. Da sich die Wärme, die über die zweite Öffnung zugeführt wird, über die Aussparung von Innen auch in die dritte Öffnung erstrecken kann, kann sich das Medium durch die Wärme verflüssigen und kann aufgrund der Gravitation in die Aussparung an die Lötpads und eingeführten Leiter gelangen. Das Medium unterstützt die Verbindung zwischen Lötpads und Leitern aufgrund seiner chemischen Eigenschaften, so dass eine zuverlässige Verbindung hergestellt werden kann.

Die folgende Beschreibung von Ausführungsbeispielen erfolgt unter Bezugnahme auf die begleitenden Figuren. Dabei zeigen:
- Fig. 1: eine perspektivische Ansicht eines Ausführungsbeispiels eines Verbinders;
- Fig. 2: eine perspektivische Ansicht eines Ausführungsbeispiels einer Leiterplatte mit daran befestigtem Verbinder und einer in den Verbinder eingeführten Leitung;
- Fig. 3: eine Querschnittsansicht der Darstellung aus Fig. 2; und
- Fig. 4: eine perspektivische Ansicht eines zweiten Ausführungsbeispiels eines Verbinders.

Im Folgenden werden Ausführungsbeispiele im Detail mit Bezug auf die Figuren beschrieben.

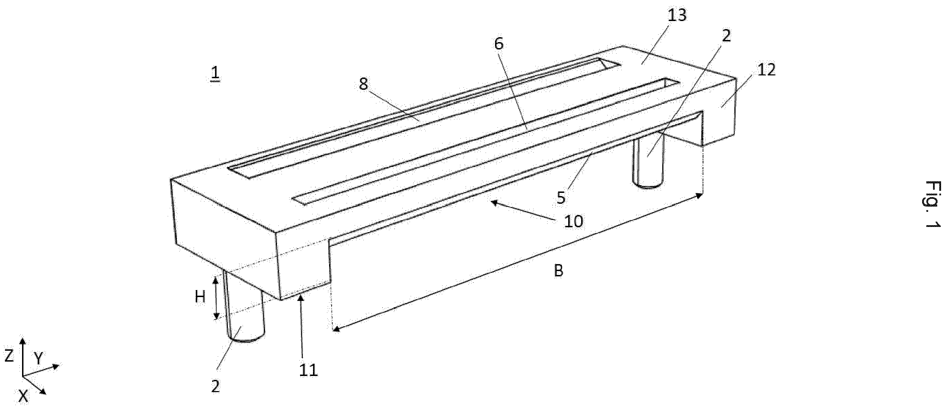

Fig. 1 zeigt ein erstes Ausführungsbeispiel eines Verbinders 1. Der Verbinder 1 ist geeignet zumindest einen Leiter 32 an einer Leiterplatte 20 direkt zu befestigen und elektrisch zu kontaktieren. Der Begriff direkt meint ohne Verwendung eines Stecker-oder Anschlusssystems. Der Verbinder 1 wird für seine Verwendung an der Leiterplatte 20 befestigt. Grundsätzlich ist es möglich Verbinder 1 sowohl auf der Oberseite 22 als auch auf einer Unterseite einer Leiterplatte 20 anzuordnen. Die Befestigung kann manuell oder automatisiert/maschinell erfolgen. Zur Befestigung weist der Verbinder 1 Befestigungsmittel 2 auf. In Fig. 1 umfassen die Befestigungsmittel 2 zwei Stifte oder Pins, die geeignet sind in entsprechende Öffnungen oder Aussparungen an der Leiterplatte 20 einzugreifen und eine haltbare Verbindung zu bilden. In alternativen Ausführungsbeispielen können die Befestigungsmittel 2 auch nur ein oder eine Mehrzahl an Befestigungsmitteln 2 umfassen. Bevorzugt ermöglichen die Befestigungsmittel 2 eine ausgerichtete Anordnung des Verbinders 1 auf der Leiterplatte 20. Die Befestigungsmittel 2 können zusätzliche Klemm- oder Rastelemente aufweisen oder formschlüssig oder pilzförmig ausgebildet sein. Beispielsweise können die in Fig. 1 gezeigten Stifte an ihren freien Enden eine Pilzform aufweisen. Weiterhin kann der Verbinder 1 durch Klebflächen an einer ersten Seite 11 des Verbinders 1 an der Leiterplatte 20 zusätzlich oder alternativ zu den oben genannten Befestigungsmitteln 2 befestigt werden.

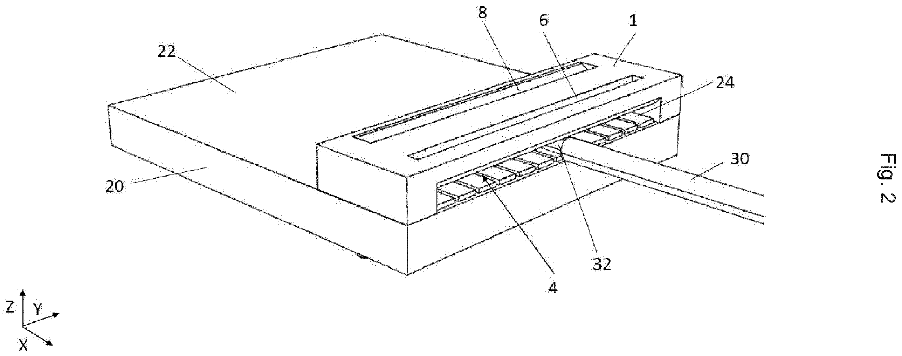

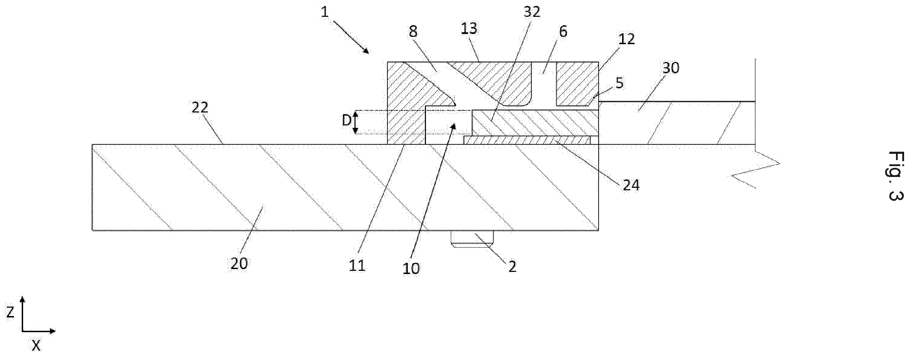

Der Verbinder 1 bildet eine Art Rahmenstruktur. Insbesondere kann der Verbinder 1 mit seiner Aussparung 10 auf eine Fläche oder ein passendes Objekt aufgesetzt werden und umrahmt die Fläche bzw. das Objekt auf mehreren Seiten. Durch die Umrahmung ist der Zugang zu der Fläche bzw. dem Objekt begrenzt und vorgegeben. Weiterhin ist die Fläche bzw. das Objekt durch den Verbinder 1 vor ungewollten äußeren Einflüssen geschützt. In dem dargestellten Ausführungsbeispiel ist ein Lötpad 24 bzw. eine Mehrzahl an Lötpads 24 auf der Leiterplatte 20 ein Objekt, das nach dem Aufsetzten des Verbinders 1 auf die Leiterplatte 20 von der Leiterplatte 20 und dem Verbinder 1 umrahmt wird (s. Figs. 2 und 3). Die Leiterplatte 20 kann auch als PCB Board oder Platine bezeichnet werden. Lötpads 24 sind elektrisch leitende Kontaktflächen. Über die Lötpads 24 kann eine elektrische Verbindung zwischen einem Leiter 32 und den Leiterbahnen auf der Leiterplatte 20 hergestellt werden.

Der Zugang von außen mit einem Leiter 32 an das Lötpad 24 bzw. an die Mehrzahl von Lötpads 24 kann bzw. soll über eine erste Öffnung 4 erfolgen. Die erste Öffnung 4 ist ein Teil der Aussparung 10 an dem Verbinder 1. Der Teil der Aussparung 10 wird durch die Leiterplatte 20 begrenzt, so dass die erste Öffnung 4 gebildet wird. Die erste Öffnung 4 weist bevorzugt eine Höhe H auf, die im Wesentlichen dem Durchmesser D eines Leiters 32 entspricht, der in den Verbinder 1 eingeführt werden soll. Der Ausdruck im Wesentlichen umfasst Toleranzen, so dass zum Beispiel neben dem Leiter 32 auch das Lötpad 24 Platz findet (s. Fig. 3). Zudem kann die Außenkante der ersten Öffnung 4 eine etwas größere Höhe aufweisen, welche sich dann über zumindest eine Einführhilfe 5 reduziert. Die etwas größere Höhe an der Seitenkante in Verbindung mit der zumindest einen Einführhilfe 5, die bevorzugt als Einführschräge ausgebildet ist, erleichtert das Einführen eines Leiters 32 in den Verbinder 1. Zusätzliche Einführhilfen 5 bzw. Einführschrägen können auch an anderen Seitenkanten der ersten Öffnung 4, insbesondere auch an der Leiterplatte 20, gebildet sein.

Die zumindest eine Leitung 30, die über den Verbinder 1 mit der Leiterplatte 20 verbunden werden soll, umfasst bevorzugt eine einadrige Leitung 30 mit einem Leiter 32. In alternativen Ausführungsbeispielen können auch mehradrige Leitungen über den Verbinder 1 an der Leiterplatte 20 angeschlossen sein. Der Leiter 32 umfasst bevorzugt eine Ader, eine Litze oder einen Draht der Leitung 30. Der Leiter 32 ist insbesondere nach einer Vorkonfektion, die unter anderem eine Abmantelung der Leiterisolierung oder des Schirm-/Außenleiters und des Dielektrikums umfasst, in einem Teil eines Leitungsendes freigelegt. Insbesondere ist der Verbinder 1 eingerichtet sehr dünne Litzen zuverlässig mit der Leiterplatte 20 zu verbinden, da keine zusätzlichen Steckersysteme notwendig sind. Die Breite B der ersten Öffnung 4 ist bevorzugt an die Anzahl an Lötpads 24 auf der Leiterplatte 20 und damit an die maximale Anzahl an zu verbindenden Leitern 32 angepasst. In einer bevorzugten Ausführungsform ist die Breite B der ersten Öffnung 4 so gewählt, dass die Leitungen 30, die an die Leiterplatte 20 angeschlossen werden sollen, dicht aneinandergereiht angeordnet sind, während jeder Leiter 32 auf einem separaten Lötpad 24 beabstandet voneinander in dem Verbinder 1 angeordnet ist (s. Fig. 2). Die Leitung 30 kann auch eine Koaxialleitung umfassen, wobei der Außenleiterschirm außerhalb der Leiterplatte 20 angebunden wird. Bevorzugt liegt die Abmantelungskante der Leitung 30 an einer Kante der Leiterplatte 20 oder wird dazu ausgerichtet.

Das zumindest eine Lötpad 24 umfasst bevorzugt eine Lötpaste oder dergleichen. Beim Einführen eines Leiters 32 in den Verbinder 1 kommt der Leiter 32 direkt in Kontakt mit dem Lötpad 24. Insbesondere wird der Leiter 32 beim Einführen zumindest teilweise in das Lötpad 24 hineingedrückt. Durch die pastenartige Substanz des Lötpads 24 wird der eingeführte Leiter 32 durch Reibung bzw. Adhäsionskräfte an dem Lötpad 24 gehalten. Durch das Lötpad 24 ist der eingeführte Leiter 32 an dem Verbinder 1 vorfixiert. Das zumindest eine Lötpad 24 ist bevorzugt vor dem Anordnen des Verbinders 1 auf der Leiterplatte 20 aufgebracht. Die Anzahl der bzw. die Anordnung des zumindest einen Lötpads 24 ist durch die Footprint Vorgabe der Leiterplatte 20 gegeben. Insbesondere kann das zumindest eine Lötpad 24 vor- und/oder oberflächenbehandelt sein und dadurch ein Depot für eine Verlötung von Lötpad 24 und Leiter 32 bereitstellen. Nach dem Einbringen des Leiters 32 in den Verbinder 1 liegt der Leiter 32 bevorzugt möglichst parallel zur Leiterplatte 20 in der Mitte des zugeordneten, dafür vorgesehenen Lötpads 24.

Um den Leiter 32 dauerhaft mit der Leiterplatte 20 zu verbinden und eine elektrische Verbindung herzustellen wird der Leiter 32 bevorzugt an das Lötpad 24 gelötet. Zum Löten ist der Leiter 32 bevorzugt vor und/oder oberflächenbehandelt, zum Beispiel verzinnt. Weiterhin wird zum Löten eine Wärme über eine zweite Öffnung 6 in den Verbinder 1 eingebracht. Die zweite Öffnung 6 ist im Wesentlichen über die Breite B der ersten Öffnung 4 ausgebildet, so dass die Wärme an alle eingeführten Leiter 32, gezielt auf einzelne Leiter 32 oder flächig, eingebracht werden kann. Die Wärme kann direkt oder indirekt, zum Beispiel über Schwingungen wie Laser oder Infrarot, zugeführt werden. Wenn der Verbinder 1 aus einem nicht-wärmeleitendem Material hergestellt ist, bildet die zweite Öffnung 6 die einzige Stelle, an der Wärme zum Löten der Leiter 32 in den Verbinder 1 eingebracht werden kann. Insbesondere bei mehrreihigen Verbindern kann der Verbinder 1 aus wärmeleitendem Material hergestellt sein, um die Wärme großflächig weiterzuleiten und zuverlässige Verbindungen zu erzeugen.

Weiterhin kann dem Verbinder 1 über eine dritte Öffnung 8 ein Medium zugeführt werden. Das Medium kann die Verlötung unterstützen und/oder die Vorbehandlung des Lötpads 24 und/oder des Leiters 32 ergänzen. Insbesondere kann die dritte Öffnung 8 ein Lötdepot umfassen, in dem das Medium gespeichert werden kann. Das Lötdepot kann die dritte Öffnung 8 selbst sein oder ein separater Speicher. In einem bevorzugten Ausführungsbeispiel liegt das Medium, vor dem Verlöten, in fester Form in der dritten Öffnung 8 vor. Beim Löten verflüssigt sich das Medium aufgrund der auftretenden Wärme im Verbinder 1 und bewegt sich Stück für Stück in den Verbinder 1 auf die Lötstelle.

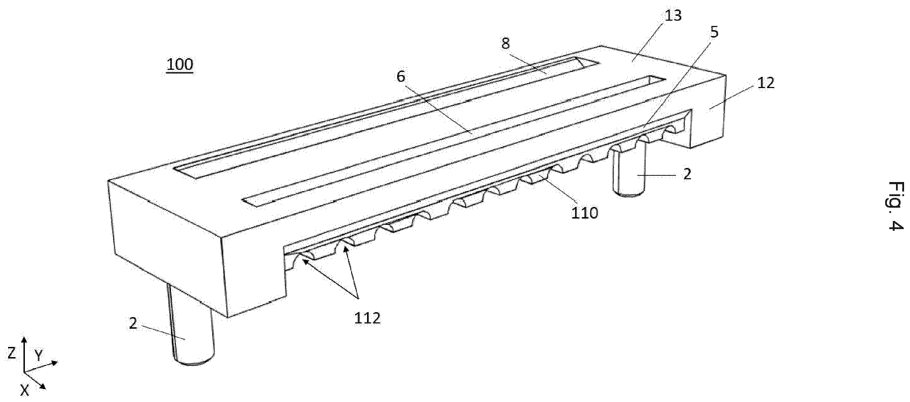

Fig. 4 zeigt ein zweites Ausführungsbeispiel eines Verbinders 100. Das zweite Ausführungsbeispiel des Verbinders 100 umfasst insbesondere Ausrichtungsmittel 110 zum Ausrichten bzw. gerichtetem Einführen des zumindest einen Leiters 32 in den Verbinder 100. Die Ausrichtungsmittel 110 umfassen bevorzugt Halbbögen 112 bzw. eine Leiste mit einer offenen gekrümmten/gebogenen Profilierung. Durch die Halbbögen 112 bzw. die Profilierung kann jeder Leiter 32 an einer bestimmten Stelle und gleichmäßig beabstandet voneinander in dem Verbinder 100 angeordnet werden kann. Das Ausrichtungsmittel 110 ist bevorzugt integral mit dem Verbinder 100 ausgebildet. In einem alternativen Ausführungsbeispiel kann das Ausrichtungsmittel 110 als separates Bauteil an dem Verbinder 100 befestigt sein. Die Anzahl an Halbbögen 112 entspricht bevorzugt der Anzahl an Lötpads 24 in dem Verbinder 100 auf der Leiterplatte 20.

Der Verbinder 1 ist bevorzugt aus einem elektrisch nicht-leitfähigem Material, insbesondere einem Kunststoff, gebildet.

### BEZUGSZEICHENLISTE

- 1: Verbinder
- 2: Befestigungsmittel
- 4: erste Öffnung
- 5: Einführhilfe
- 6: zweite Öffnung
- 8: dritte Öffnung
- 10: Aussparung
- 11: erste Seite
- 12: zweite Seite
- 13: dritte Seite
- 20: Leiterplatte
- 22: Oberseite
- 24: Lötpad
- 30: Leitung
- 32: Leiter
- 100: Verbinder
- 110: Ausrichtungsmittel
- 112: Halbbogen
- B: Breite
- D: Durchmesser
- H: Höhe
- X, Y, Z: Achsrichtungen

## Patentansprüche

1. Verbinder (1, 100) zum Verbinden einer Leiterplatte (20), die zumindest ein Lötpad (24) aufweist, mit zumindest einem Leiter (32) einer Leitung (30), aufweisend:
a) Befestigungsmittel (2), mit Hilfe derer der Verbinder (1, 100) an der Leiterplatte (20) befestigbar ist;
b) eine Aussparung (10), die an einer ersten Seite (11) des Verbinders (1, 100) gebildet ist, und die sich zumindest über eine zweite Seite (12), die quer zur ersten Seite (11) angeordnet ist, erstreckt, wobei in einem montierten Zustand des Verbinders (1, 100) auf der Leiterplatte (20) das zumindest eine Lötpad (24) in der Aussparung (10) auf der ersten Seite (11) anordbar ist und die Aussparung (10) auf der zweiten Seite (12) eine erste Öffnung (4) bildet, in die der zumindest eine Leiter (32) einführbar ist; und
c) eine zweite Öffnung (6), die an einer der ersten Seite (11) gegenüberliegenden dritten Seite (13) gebildet ist, wobei über die zweite Öffnung (6) Wärme zum Verbinden des zumindest einen Leiters (32) mit dem zumindest einen Lötpad (24) bereitgestellt werden kann.

2. Verbinder nach Anspruch 1, bei dem der Verbinder (1, 100) eingerichtet ist parallel eine Mehrzahl von Leitern (32) mit einer entsprechenden Mehrzahl an Lötpads (24) zu verbinden, wobei insbesondere die erste Öffnung (4) eine Breite (B) aufweist, die geeignet ist die Mehrzahl von Leitern (32) parallel aufzunehmen.

3. Verbinder nach Anspruch 1 oder 2, bei dem im montierten Zustand zumindest eine Seite der ersten Öffnung (4) aus der Leiterplatte (20) gebildet ist.

4. Verbinder nach einem der Ansprüche 1 - 3, bei dem die Befestigungsmittel (2) Pins oder Stifte umfassen, die in entsprechende Öffnungen an der Leiterplatte (20) eingreifbar sind.

5. Verbinder nach einem der Ansprüche 1 - 4, bei dem der Verbinder (1, 100) an der ersten Seite (11) Klebeflächen aufweist.

6. Verbinder nach einem der Ansprüche 1 - 5, bei dem im montierten Zustand eine Höhe (H) der ersten Öffnung (4) einem Durchmesser (D) des zumindest einen Leiters (32) entspricht.

7. Verbinder nach einem der Ansprüche 1 - 6, bei dem die erste Öffnung (4) zumindest eine Einführhilfe (5) aufweist.

8. Verbinder nach einem der Ansprüche 1 - 7, bei dem die erste Öffnung (4) zumindest ein Ausrichtungsmittel (110) aufweist.

9. Verbinder nach einem der Ansprüche 1 - 8, weiterhin aufweisend eine dritte Öffnung (8), die an der dritten Seite (13) gebildet ist, wobei über die dritte Öffnung (8) ein Medium an den zumindest einen Leiter (32) und das zumindest eine Lötpad (24) zugeführt werden kann.

10. Verbinder nach Anspruch 9, bei dem die dritte Öffnung (8) ein Depot für das Medium aufweist oder bildet.

11. Verbinder nach einem der Ansprüche 1 - 10, bei dem der Verbinder (1, 100) aus einem nicht-wärmeleitendem Material gebildet ist.

12. Leiterplatte (20), die zumindest ein Lötpad (24) und einen Verbinder (1, 100) nach einem der Ansprüche 1 - 11 aufweist, so dass die Leiterplatte (20) direkt mit zumindest einem Leiter (32) einer Leitung (30) verbunden werden kann.

13. Verfahren zum Verbinden einer Leiterplatte (20), die zumindest ein Lötpad (24) aufweist, mit zumindest einem Leiter (32) einer Leitung (30), wobei das Verfahren die folgenden Schritte aufweist:
a) Anordnen eines Verbinders (1, 100), insbesondere eines Verbinders (1, 100) nach einem der Ansprüche 1 - 11, an einer vorbestimmten Position auf der Leiterplatte (20), wobei Befestigungsmittel (2) des Verbinders (1, 100) in Eingriff mit der Leiterplatte (20) kommen und das zumindest eine Lötpad (24) in einer Aussparung (10) des Verbinders (1, 100) angeordnet ist;
b) Einführen des zumindest einen Leiters (32) in eine erste Öffnung (4) an dem Verbinder (1, 100), wobei die Einführbewegung bevorzugt entlang der Leiterplattenebene (X-Y) gerichtet ist, so dass ein eingeführter Leiter (32) innerhalb des Verbinders (1, 100) in Kontakt mit einem Lötpad (24) steht;
c) Einbringen von Wärme über eine zweite Öffnung (6) an dem Verbinder (1, 100), so dass sich ein eingeführter Leiter (32) mit einem in Kontakt stehenden Lötpad (24) verbindet.

14. Verfahren nach Anspruch 13, bei dem im Schritt des Einführens des zumindest einen Leiters (32), der eingeführte Leiter (32) zumindest teilweise in das Lötpad (24) hineingedrückt wird.

15. Verfahren nach Anspruch 13 oder 14, weiterhin aufweisend den Schritt: Einbringen eines Mediums, das die Verbindung zwischen dem zumindest einen Lötpad (24) und dem zumindest einen eingeführten Leiter (32) unterstützt, wobei das Einbringen bevorzugt über eine dritte Öffnung (8) an dem Verbinder (1, 100) erfolgt.
